# EUROPÄISCHE PATENTSCHRIFT

(11) **EP 3 152 837 B1**
(45) Veröffentlichungstag und Bekanntmachung des Hinweises auf die Patenterteilung: **07.08.2019**
(21) Anmeldenummer: 15726146.2
(22) Anmeldetag: 01.06.2015
(51) Int. Cl.: H03K 17/98, H03K 17/967

(54) **VORRICHTUNG ZUR BEDIENUNG MEHRERER FUNKTIONEN IN EINEM KRAFTFAHRZEUG**
DEVICE FOR CONTROLLING MULTIPLE FUNCTIONS IN A MOTOR VEHICLE
DISPOSITIF DE COMMANDE DE PLUSIEURS FONCTIONS DANS UN VÉHICULE AUTOMOBILE

(30) Priorität: 06.06.2014 DE 102014008459; 06.06.2014 DE 102014008464
(43) Veröffentlichungstag der Anmeldung: 12.04.2017
(73) Patentinhaber: Leopold Kostal GmbH & Co. KG, 58513 Lüdenscheid (DE)
(72) Erfinder: BLECKMANN, Michael, 58239 Schwerte-Ergste (DE); BORGMANN, Uwe, 45665 Recklinghausen (DE)
(74) Vertreter: Kerkmann, Detlef
(86) Internationale Anmeldenummer: PCT/EP2015/062166
(87) Internationale Veröffentlichungsnummer: WO 2015/185512

(56) Entgegenhaltungen:
- WO-A1-2012/168326
- DE-B3-102007 054 347
- DE-B3-102012 221 107

## Beschreibung

Die Erfindung betrifft eine Vorrichtung zur Bedienung mehrerer Funktionen in einem Kraftfahrzeug, mit einer mehrere Bedienfelder aufweisenden Schalterleiste, welche um eine Drehachse verschwenkbar gelagert ist, wobei durch eine manuelle Betätigung der Schalterleiste in Abhängigkeit davon, auf welchem der Bedienfelder sie betätigt wird, unterschiedliche Funktionen ausgelöst werden, und mit Mitteln zur Erkennung, auf welchem ihrer Bedienfelder die Schalterleiste betätigt wird.

Eine derartige Vorrichtung ist aus der deutschen Offenlegungsschrift DE 10 2010 024 776 A1 bekannt. Bei einer Ausführungsform der in diesem Dokument beschriebenen Vorrichtung ist eine mehrere Bedienfelder aufweisende Schalterleiste um eine Drehachse verschwenkbar gelagert. Die Schalterleiste weist mehrere kapazitive Sensorflächen als Mittel zur Erkennung, auf welchem ihrer Bedienfelder sie betätigt wird, auf. Durch ein Verschwenken der Schalterleiste können Schaltbausteine oder Schaltkontakte betätigt und so Schaltfunktionen ausgelöst werden.

Die DE 10 2010 024 776 A1 offenbart damit das Funktionsprinzip einer Vorrichtung, welche berührungssensitive und druckbetätigbare kontaktierende Schaltelemente kombiniert. Als Schaltelemente werden insbesondere Kippschalter vorgeschlagen. Das Betätigen von Kippschaltern erfordert einen haptisch deutlichen wahrnehmbaren Betätigungsweg, der über das hebelartig wirkende Bedienelement noch vergrößert wird. Ein derartig weiter Betätigungsweg ist nicht in jedem Fall erwünscht. Darüber hinaus ergeben sich durch die Verwendung kapazitiver Sensorflächen Einschränkungen hinsichtlich der Materialauswahl für die Schalterleiste. So können insbesondere keine metallischen oder metallisierten Materialien verwendet werden.

Die DE 10 2007 054 347 A1 und die WO 2012/168326A1 offenbaren jeweils Bedieneinheiten für Fahrzeugkomponenten mit manuell betätigbaren Tastenelementen, die über filmscharnierartige Anbindungen mit feststehenden Gehäuseteilen verbunden sind. Die umlaufenden Ränder der Tastenelemente können dabei außerhalb ihrer jeweiligen Filmscharnieranbindungen freiliegend sein oder über dünne Stege miteinander oder mit dem Gehäuse verbunden. Eine manuelle Betätigung eines der Tastenelemente bewirkt dabei jeweils eine Kraftbeaufschlagung eines dem jeweiligen Tastenelement zugeordneten elektrischen Schaltelements.

Die DE 101 2012 221 107 B3 zeigt eine Bedienvorrichtung für Fahrzeugkomponenten mit einem als starre Betätigungsleiste ausgebildeten Tastenkörper. Die Betätigungsleiste weist mehrere Symbolfelder auf, wobei durch eine manuelle Betätigung der Betätigungsleiste in Abhängigkeit davon, auf welchem der Symbolfelder sie betätigt wird, unterschiedliche Funktionen ausgelöst werden. Die Erkennung, auf welchem der Symbolfelder die Betätigung erfolgt, geschieht mittels einer kapazitiven Näherungssensorik.

Die Vorrichtung gemäß der vorliegenden Erfindung hat gegenüber dem zuvor beschriebenen Stand der Technik den Vorteil, eine Ausführung der Schalterleiste auch mit metallischen oder metallisierten Materialien zu ermöglichen und dennoch nur sehr geringe Schalthübe zu erfordern.

Dies wird erfindungsgemäß durch die Vorrichtung gemäß Anspruch 1 erreicht wobei die Schalterleiste bezüglich ihrer Längserstreckung biegeweich und bezüglich der dazu senkrechten Quererstreckung in Bedienrichtung biegesteif ausgeführt ist, indem sie eine flache, in sich biegeweiche Betätigungsplatte sowie mit dieser verbundene, die Biegesteifigkeit in der Quererstreckung erzeugende Versteifungsrippen umfasst, die im Bereich ihrer der Verbindung mit der Betätigungsplatte abgewandten Enden die Drehachse aufnehmen, und dass der Schalterleiste mehrere in Richtung ihrer Längserstreckung verteilt angeordnete Kraftsensoren zugeordnet sind.

Eine vorteilhafte Ausführungsform der erfindungsgemäßen Vorrichtung sieht vor, dass die Kraftsensoren das bei Betätigung der Schalterleiste um die Drehachse aufgebrachte Drehmoment abstützen und darüber hinaus zur Ermittlung eines bei Betätigung der Schalterleiste aufgrund ihrer Biegeweichheit bezüglich ihrer Längserstreckung erzeugten Kraftprofils dienen, das insbesondere zur Erkennung herangezogen ist, auf welchem ihrer Bedienfelder die Schalterleiste betätigt wird.

Eine bevorzugte Weiterbildung der Vorrichtung ist mit Mitteln zum Erzeugen einer haptischen Rückmeldung beim Betätigen der Schalterleiste versehen, insbesondere in Form eines elektromagnetischen Aktuators, der so angeordnet ist, dass durch diesen die Betätigungsplatte zu einer Verschiebung parallel zu der Drehachse ansteuerbar ist. Dies ist z.B. dadurch erleichtert, dass die Schalterleiste im Wesentlichen aus Kunststoff besteht, und die Versteifungsrippen mit jeweils zwei als Filmscharnieren ausgebildeten Gelenken versehen sind, die Bewegungen der Versteifungsrippen um Achsen, die zur Richtung der Betätigung der Schalterleiste parallel sind, ermöglichen.

In einer besonders kompakten Ausführungsform dieser Weiterbildung umfasst der elektromagnetische Aktuator einen gegenüber der Schalterleiste ortsfest angebrachten elektrischen Haftmagneten, der mit einem mit der Schalterleiste fest verbundenen ferromagnetischen Element kooperiert. Dieser elektrische Haftmagnet ist dabei bevorzugt mit dem ferromagnetischen Element unter Zwischenlage eines nichtmagnetischen elastischen Elements, welches etwa aus Gummi, Silikon, einem thermoplastischen Elastomer oder einem ähnlichen Werkstoff bestehen kann, kraftschlüssig verbunden.

Die verwendeten Kraftsensoren können etwa als scheibenförmige Sensoren ausgebildet sein, die nach einem kapazitiven Wirkprinzip funktionieren. Solche, beispielsweise parallele Kondensatorscheiben aufweisende Sensoren können besonders in Betätigungsrichtung sehr kleine Abmessungen aufweisen und Kräfte über einen kurzen Betätigungsweg erfassen. Alternativ können die Kraftsensoren auch als piezoelektrische Sensoren ausgeführt sein.

Nachfolgend ist die Erfindung unter Bezugnahme auf die beigefügte Zeichnung erläutert.

Dabei zeigen:
- **Fig. 1:**: eine schematische Darstellung der Schalterleiste einer erfindungsgemäßen Vorrichtung
a) in Aufsicht
b) in einer Seitenansicht einschließlich der Zuordnung eines Kraftsensors
- **Fig. 2:**: eine schematische Darstellung einer Weiterbildung der Schalterleiste gemäß Fig. 1
- **Fig. 3:**: eine schematische Darstellung eines erfindungsgemäß verwendeten elektromagnetischen Aktuators, verbunden mit einer Betätigungsplatte der Schalterleiste

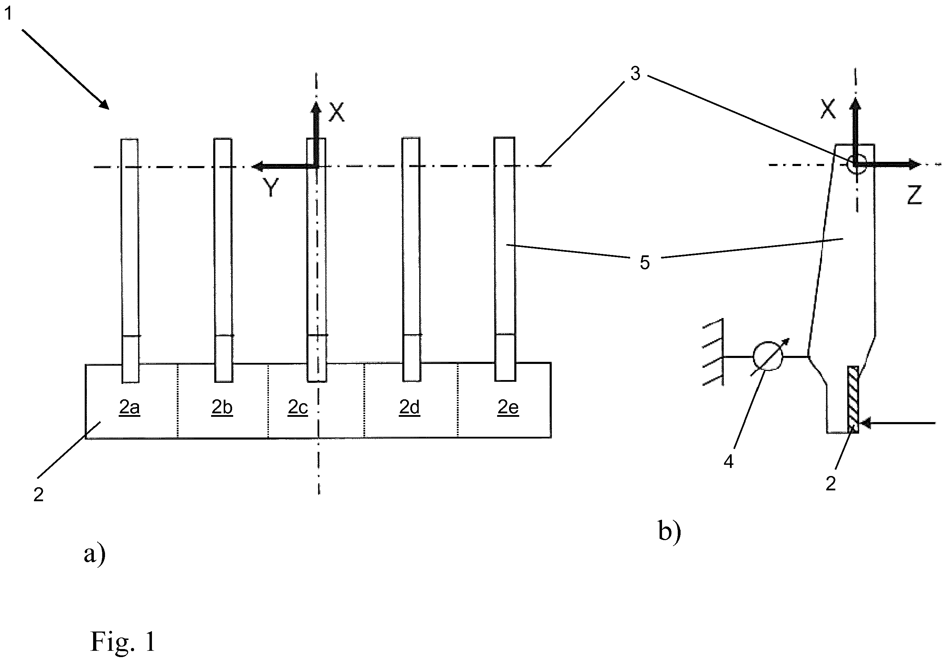

Die Figur 1 zeigt eine Schalterleiste 1 einer erfindungsgemäß ausgebildeten Vorrichtung in einer schematischen Darstellung. Die Schalterleiste 1 ist zur Bedienung mehrerer Funktionen in einem Kraftfahrzeug vorgesehen und weist dazu mehrere Bedienfelder 2a, 2b, ... auf, wobei jedes dieser Bedienfelder zumindest einer der bedienbaren Funktionen in der Weise zugeordnet ist, dass bei einer manuellen Betätigung der Schalterleiste 1 in Abhängigkeit davon, auf welchem der Bedienfelder 2a, 2b, ... sie betätigt wird, die diesem jeweils zugeordnete Funktionen ausgelöst wird.

Die Schalterleiste 1 ist zur Ermöglichung der Betätigung um eine Drehachse 3, die in der Zeichnung auch als Y-Achse bezeichnet ist, verschwenkbar gelagert. Sie besteht im Wesentlichen aus einer flachen, in sich relativ biegeweichen Betätigungsplatte 2, auf deren in der Darstellung sichtbaren Oberfläche die Bedienfelder 2a, 2b, ... angeordnet sind. Mit der Betätigungsplatte 2 fest verbunden sind mehrere Versteifungsrippen 5, die sich parallel zu der in der Zeichnung mit X bezeichneten Achse erstrecken. Die Versteifungsrippen 5 erzeugen durch ihre Ausrichtung in X-Richtung und ihre Verbindung mit der Betätigungsplatte 2 deren Biegesteifigkeit in ihrer Quererstreckung. Im Bereich ihrer der Verbindung mit der Betätigungsplatte 2 abgewandten Enden nehmen die Versteifungsrippen 5 die Drehachse 3 auf, um die sie frei drehbeweglich sind. Insgesamt bewirkt die beschriebene Anordnung also, dass die Schalterleiste 1 bezüglich ihrer Längserstreckung biegeweich und bezüglich der dazu senkrechten Quererstreckung biegesteif ausgeführt ist.

Der Schalterleiste 1 sind mehrere in Richtung ihrer Längserstreckung verteilt angeordnete Kraftsensoren 4 zugeordnet. Diese sind in der dargestellten Ausführungsform so angeordnet, dass sich unter jeder Versteifungsrippe 5 jeweils ein Kraftsensor 4 befindet, der ein bei auf die jeweilige Versteifungsrippe 5 bei Drehung um die Drehachse 3 ausgeübtes Drehmoment abstützt und die entsprechende Kraft misst. Bei einer an einem beliebigen Ort auf der Betätigungsplatte 2 erfolgenden Krafteinleitung im Sinne einer Betätigung erfährt der diesem Ort am nächsten liegende Kraftsensor 4 die höchste Kraft. Da die Betätigungsplatte 2 auch in ihrer Längserstreckung nur begrenzt biegeweich ist, erfahren auch die benachbarten Kraftsensoren 4 noch Betätigungskräfte, die jedoch mit der Entfernung von dem Ort der Krafteinleitung immer geringer werden. Aus der Verteilung bzw. dem Profil der bei einer Betätigung der Schalterleiste 1 gemessenen Kräfte aller Kraftsensoren 4 lässt sich somit nicht nur die Betätigung als solche feststellen, sondern auch der Ort der Krafteinleitung, und somit das mit der Betätigung gemeinte Bedienfeld 2a, 2b, ... ermitteln.

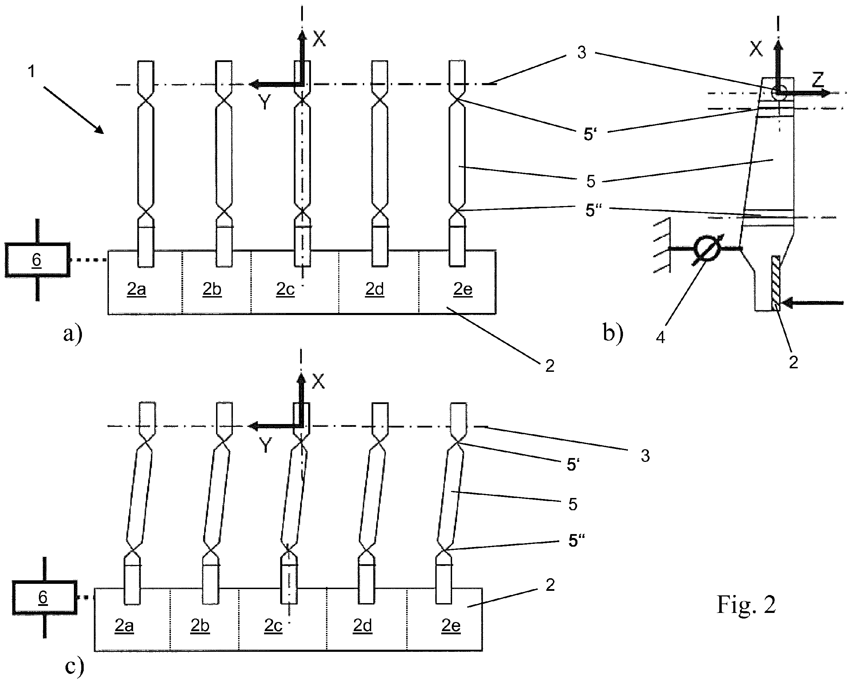

Die Fig. 2 zeigt eine Weiterbildung der Schalterleiste 1 zur Ermöglichung einer Bewegung der Schalterleiste 1 in einer Richtung parallel zu der Drehachse 3, also gemäß der Darstellung in Y-Richtung. Durch eine solche Bewegung mittels des eines ebenfalls schematisch dargestellten Aktuators 6 in Form etwa eines Elektromagneten kann eine haptische Rückmeldung realisiert werden.

Im Unterschied zu der Ausführung gemäß Fig. 1 sind die die Versteifungsrippen 5 hier zusätzlich mit jeweils zwei als Filmscharnieren ausgebildeten Gelenken 5', 5" versehen. Die Betätigungsplatte 2 und die Versteifungsrippen 5 sind dabei vorzugsweise als Kunststoffteil einstückig miteinander ausgebildet. Die Gelenke 5', 5" befinden sich jeweils in der Nähe der Drehachse 3 sowie in der Nähe der Verbindung der Versteifungsrippe 5 mit der Betätigungsplatte 2. Sie ermöglichen Bewegungen der Versteifungsrippen 5 um Achsen, die zu in der Darstellung als Z-Achse bezeichneten Richtung parallel sind. Diese Richtung entspricht im Wesentlichen der Richtung der Betätigung der Schalterleiste 1. Wie insbesondere aus Fig. 2 c) ersichtlich, ergibt sich durch die jeweils zwei Gelenke 5', 5" jeweils einer Versteifungsrippe 5 die Möglichkeit, durch parallele Knickungen aller Versteifungsrippen 5 mit Hilfe eines Aktuators 6 eine Verschiebung der Betätigungsplatte 2 in Y-Richtung, also parallel zu der Drehachse 3 vorzunehmen. Die gleichzeitig auch in X-Richtung erfolgende Verschiebung ist praktisch vernachlässigbar, da bereits die Verschiebung in Y-Richtung nur um einen sehr geringen Betrag erfolgt.

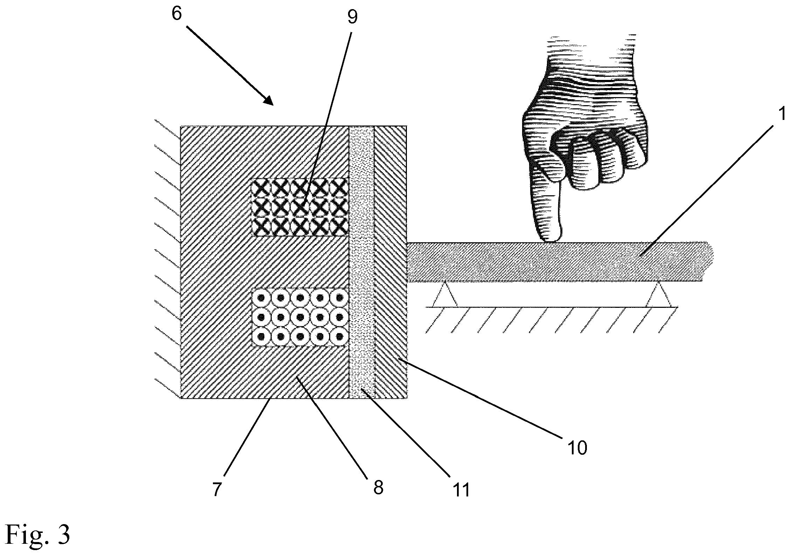

In Fig. 3 ist eine bevorzugte Ausführungsform des elektromagnetischen Aktuators 6 schematisch dargestellt, die einen besonders kompakten Aufbau der gesamten Anordnung ermöglicht. Der elektromagnetische Aktuator 6 besteht dabei im Wesentlichen aus einem gegenüber der Schalterleiste 1 ortsfest angebrachten elektrischen Haftmagneten 7. Dieser elektrische Haftmagnet 7 besteht aus einem im Querschnitt kreisrunden und in dem hier dargestellten Längsschnitt E-förmig ausgebildeten ferromagnetischen Kern 8, in dem eine Spule 9 aus Kupferdraht aufgenommen ist. Durch Bestromung der Spule 9 kann ein magnetisches Feld erzeugt werden, durch das eine anziehende Kraftwirkung auf ein in der Nähe befindliches ferromagnetisches Element wie z.B. ein Eisenplättchen 10 ausgeübt wird.

Der elektrische Haftmagnet 7 ist mit einem solchen Eisenplättchen 10 unter Zwischenlage eines nichtmagnetischen elastischen Plättchens 11 verbunden, welches etwa aus Gummi, Silikon, einem thermoplastischen Elastomer oder einem ähnlichen Werkstoff bestehen kann. Bei Bestromung der Spule 9 zieht der Haftmagnet 7 das Eisenplättchen 10 an und dieses bewegt sich auf den Haftmagneten 7 zu, wobei das elastische Plättchen 11 zusammengepresst wird. Wird die Bestromung der Spule 9 unterbrochen, entspannt sich das elastische Plättchen 11 und das Eisenplättchen 10 wird in seine ursprüngliche Position zurück verlagert.

## Patentansprüche

1. Vorrichtung zur Bedienung mehrerer Funktionen in einem Kraftfahrzeug, mit einer mehrere Bedienfelder (2a, 2b, ...) aufweisenden Schalterleiste (1), welche um eine Drehachse (3) verschwenkbar gelagert ist, wobei durch eine manuelle Betätigung der Schalterleiste (1) in Abhängigkeit davon, auf welchem der Bedienfelder (2a, 2b, ...) sie betätigt wird, unterschiedliche Funktionen ausgelöst werden, und mit Mitteln zur Erkennung auf welchem ihrer Bedienfelder (2a, 2b, ...) die Schalterleiste (1) betätigt wird, **dadurch gekennzeichnet, dass** die Schalterleiste (1) bezüglich ihrer Längserstreckung biegeweich und bezüglich der dazu senkrechten Quererstreckung in Bedienrichtung biegesteif ausgeführt ist, indem sie eine flache, in sich biegeweiche Betätigungsplatte (2) sowie mit dieser verbundene, die Biegesteifigkeit in der Quererstreckung erzeugende Versteifungsrippen (5) umfasst, die im Bereich ihrer der Verbindung mit der Betätigungsplatte (2) abgewandten Enden die Drehachse (3) aufnehmen, und dass der Schalterleiste (1) mehrere in Richtung ihrer Längserstreckung verteilt angeordnete Kraftsensoren (4) zugeordnet sind.

2. Vorrichtung nach Anspruch 1, **dadurch gekennzeichnet, dass** die Kraftsensoren (4) das bei Betätigung der Schalterleiste (1) um die Drehachse (3) aufgebrachte Drehmoment abstützen.

3. Vorrichtung nach einem der Anspruch 1 oder 2, **dadurch gekennzeichnet, dass** die Kraftsensoren (4) zur Ermittlung eines bei Betätigung der Schalterleiste (1) erzeugten Kraftprofils dienen, das zur Erkennung, auf welchem ihrer Bedienfelder (2a, 2b, ...) die Schalterleiste (1) betätigt wird, herangezogen ist.

4. Vorrichtung nach einem der Ansprüche 1 bis 3, **dadurch gekennzeichnet, dass** die Vorrichtung mit Mitteln zum Erzeugen einer haptischen Rückmeldung beim Betätigen der Schalterleiste (1) versehen ist.

5. Vorrichtung nach Anspruch 4, **dadurch gekennzeichnet, dass** in der Vorrichtung ein elektromagnetischer Aktuator (6) so angeordnet ist, dass durch diesen die Betätigungsplatte (2) zu einer Verschiebung parallel zu der Drehachse (3) ansteuerbar ist.

6. Vorrichtung nach einem der Anspruch 5, **dadurch gekennzeichnet, dass** die Schalterleiste (1) im Wesentlichen aus Kunststoff besteht, und dass die Versteifungsrippen (5) mit jeweils zwei als Filmscharnieren ausgebildeten Gelenken (5', 5") versehen sind, die Bewegungen der Versteifungsrippen (5) um Achsen, die zur Richtung der Betätigung der Schalterleiste (1) parallel sind, ermöglichen.

7. Vorrichtung nach Anspruch 5 oder 6, **dadurch gekennzeichnet, dass** der elektromagnetische Aktuator (6) einen gegenüber der Schalterleiste (1) ortsfest angebrachten elektrischen Haftmagneten umfasst, der mit einem mit der Schalterleiste (1) fest verbundenen ferromagnetischen Element unter Zwischenlage eines nichtmagnetischen elastischen Elements kraftschlüssig verbunden ist.

8. Vorrichtung nach Anspruch 7, **dadurch gekennzeichnet, dass** das nichtmagnetische elastische Element (11) aus einem elastomeren Kunststoff besteht.

9. Vorrichtung nach einem der Ansprüche 1 bis 8, **dadurch gekennzeichnet, dass** die Kraftsensoren (4) als scheibenförmige Sensoren ausgebildet sind, die nach einem kapazitiven Wirkprinzip funktionieren.

## Claims

1. Device for operating a plurality of functions in a motor vehicle, having a switch panel (1) which shows a plurality of control pads (2a, 2b, ...) and which is supported in a pivotable manner around a rotational axis (3), whereby various functions are triggered by a manual actuation of the switch panel (1) in dependence of which of the control pads (2a, 2b, ...) it is actuated on, and having a means for identifying on which of its control pads (2a, 2b, ...) the switch panel (1) is actuated, **characterised in that** the switch panel (1) is of a pliable design in respect of its longitudinal extension and of a rigid design in respect of its transverse extension perpendicular to the same in the direction of actuation **in that** it encompasses a flat actuation plate (2) which is pliable in itself and stiffening ribs (5) connected to the same which generate the flexural rigidity in the transverse extension and receive the rotational axis (3) within the range of its ends facing away from its connection to the actuation plate (2), and that a plurality of force sensors (4) disposed distributed along the longitudinal extension of the switch panel (1) are assigned to the same.

2. Device according to Claim 1, **characterised in that** the force sensors (4) support the torque applied to the rotational axis (3) upon actuating the switch panel (1).

3. Device according to Claim 1 or Claim 2, **characterised in that** the force sensors (4) serve to determine a force profile which is generated upon actuating the switch panel (1) and is implemented for the purpose of identifying on which of its control pads (2a, 2b, ...) the switch panel (1) is actuated.

4. Device according to any of Claims 1 to 3, **characterised in that** the device is provided with means for generating haptic feedback upon actuating the switch panel (1).

5. Device according to Claim 4, **characterised in that** an electromagnetic actuator (6) is disposed in the device in such a manner that the actuation plate (2) can be controlled by means of the same to achieve a displacement parallel to the rotational axis (3)

6. Device according to Claim 5, **characterised in that** the switch panel (1) is essentially composed of plastic and that each of the stiffening ribs (5) is provided with two joints designed as film hinges (5', 5") which enable the movements of the stiffening ribs (5) around axes which are parallel to the direction of actuating the switch panel (1).

7. Device according to Claim 5 or Claim 6, **characterised in that** the electromagnetic actuator (6) incorporates an electric clamping magnet which is mounted in a fixed position in respect of the switch panel (1) and is connected in an interlocking fashion to a ferromagnetic element which is permanently connected to the switch panel (1) by way of an interposed non-magnetic elastic element.

8. Device according to Claim 7, **characterised in that** the non-magnetic elastic element (11) is composed of an elastomer plastic.

9. Device according to any of Claims 1 to 8, **characterised in that** the force sensors (4) are designed as disk-shaped sensors which function according to a capacitive operating principle.

## Revendications

1. Dispositif de commande de plusieurs fonctions dans un véhicule automobile, avec une rangée de commutateurs (1), qui, présentant plusieurs champs de commande (2a, 2b,...) est montée en pivotement autour d'un axe de rotation (3), sachant que des fonctions différentes sont déclenchés par un actionnement manuel de la rangée de commutateurs (1), ceci selon par l'intermédiaire duquel des champs de commande (2a, 2b,...) elle est actionné, et avec des moyens permettant de reconnaître sur lequel de ses champs de commande (2a, 2b,...) la rangée de commutateurs (1) est actionnée,
**caractérisé en ce que**
la rangée de commutateurs (1) est souplement flexible dans son sens longitudinal et résistante à la flexion dans son sens transversal, dans la direction d'actionnement, du fait qu'elle comprend une plaque d'actionnement (2) plate, souplement flexible en elle-même, ainsi que des nervures de renforcement (5), qui, reliées à celle-ci et générant une résistance à la flexion dans le sens transversal, reçoivent l'axe de rotation (3) dans la région de leurs extrémités opposées à leur raccordement à la plaque d'actionnement (2), et que plusieurs capteurs de force (4) sont associés à la rangée de commutateurs (1), en étant répartis dans la direction de son sens longitudinal.

2. Dispositif selon la revendication 1, **caractérisé en ce que** les capteurs de force (4) assistent le couple de rotation appliqué autour de l'axe de rotation (3) lors de l'actionnement de la rangée de commutateurs (1).

3. Dispositif selon revendication 1 ou 2, **caractérisé en ce que** les capteurs de force (4) servent à la détection d'un profil de force, qui, généré lors de l'actionnement de la rangée de commutateurs (1), est mis à contribution pour reconnaître sur lequel de ses champs de commande (2a, 2b,...) la rangée de commutateurs (1) est actionnée.

4. Dispositif selon l'une des revendications 1 à 3, **caractérisé en ce que** le dispositif est pourvu de moyens destinés à générer une réponse haptique lors de la commande de la rangée de commutateurs (1).

5. Dispositif selon la revendication 4, **caractérisé en ce que,** dans le dispositif, est disposé un actionneur (6) électromagnétique de manière à ce que la plaque d'actionnement (2) puisse être commandée par celui-ci pour un déplacement parallèle à l'axe de rotation (3).

6. Dispositif selon la revendication 5, **caractérisé en ce que** la rangée de commutateurs (1) consiste essentiellement en matière synthétique et que les nervures de renforcement (5) sont pourvues chacune de deux articulations (5', 5") réalisées en forme de charnières pelliculaires, qui permettent les mouvements des nervures de renforcement (5) autour d'axes, qui sont parallèles à la direction d'actionnement de la rangée de commutateurs (1).

7. Dispositif selon revendication 5 ou 6, **caractérisé en ce que** l'actionneur (6) comprend un électroaimant adhésif, qui, installé fixement à l'opposé de la rangée (1) de commutateurs, est relié par adhérence, à un élément ferromagnétique, relié fixement à la rangée de commutateurs (1), par l'intermédiaire d'un élément élastique non magnétique.

8. Dispositif selon la revendication 7, **caractérisé en ce que** l'élément élastique, non magnétique (11) consiste en un matériau synthétique élastomère.

9. Dispositif selon l'une des revendications 1 à 8, **caractérisé en ce que** les capteurs de force (4) sont réalisés en tant que capteurs en forme de disques, qui fonctionnent selon un principe d'action capacitif.
